# EUROPEAN PATENT APPLICATION

(11) **EP 2 400 546 A1**
(43) Date of publication of application: **28.12.2011**
(21) Application number: 10166750.9
(22) Date of filing: 22.06.2010
(51) Int. Cl.: H01L 27/02

(54) **ESD protection in a standard cmos or bicmos ic process to enable high voltage input/outputs.**

(71) Applicant: Oticon A/S, 2765 Smoerum (DK)
(72) Inventor: Christensen, Kåre Tais, 2765, Smørum (DK)
(74) Representative: Nielsen, Hans Jörgen Vind

(57) **Abstract**

The application relates to a method of ESD protecting high-voltage inputs of an integrated circuit fabricated in a standard CMOS IC process, the high-voltage inputs being expected to experience nominal voltage swings that are larger than the nominal maximum voltage swing of the standard CMOS IC process. The application further relates to an IC and to an article of manufacture comprising the IC and an antenna. The object of the present application is to provide an integrated circuit in a standard CMOS process that supports larger than nominal input/output swings. The problem is solved by a) providing an ESD-diode comprising an anode and a cathode and having a forward bias voltage V_{D-FB} above which the diode allows current to flow in a forward direction from the anode to the cathode and a reverse breakdown voltage V_{D-RB} below which the diode allows current to flow in a reverse direction from the cathode to the anode; b) providing a number of ESD-sub-circuits, each comprising an ESD-diode coupled in series with a resistor, each ESD-sub-circuit having first and second electrical terminals; c) connecting the ESD-sub-circuits in parallel, the first electrical terminal being connected to a high-voltage input of the integrated circuit and the second electrical terminal being connected to a common voltage; and d) providing that the voltage swing of a high-voltage input or output is in a range between the forward bias voltage V_{D-FB} and the reverse breakdown voltage V_{D-RB} of the ESD-diode. This has the advantage of facilitating the use of a standard CMOS process for higher than nominal voltage I/Os. The invention may e.g. be used for the low power communication devices, e.g. portable devices having a wireless interface, e.g. listening devices, e.g. hearing instruments.

## Description

### TECHNICAL FIELD

The present application relates to integrated circuits for implementing radio transmitters and receivers, e.g. for low power, e.g. portable, electronic devices. The disclosure relates specifically to a method of ESD protecting high-voltage inputs or outputs of an integrated circuit fabricated in a standard CMOS or BiCMOS IC process, the high-voltage inputs or outputs being expected to experience voltage swings that are larger than the (specified) maximum voltage of I/O transistors of the standard CMOS or BiCMOS IC process.

The application furthermore relates to an integrated circuit (IC) implemented in a standard CMOS or BiCMOS process, to its use and to an article of manufacture comprising a transceiver IC and an antenna.

The disclosure may e.g. be useful in applications such as low power communication devices, e.g. portable devices having a wireless interface, e.g. listening devices, e.g. hearing instruments.

### BACKGROUND ART

When a high voltage swing (e.g. > 3.3 Vpp) is desired on an integrated circuit (IC), a special high-voltage process is typically chosen. Such processes are, however, typically not applicable for ultra-low power applications (or expensive to use).

In some cases, support of larger voltage swing gives significant benefit to the application. This is e.g. the case for an antenna interface between an RF-IC (radio frequency integrated circuit, radio frequencies (RF) being e.g. defined as the frequency range between 3 kHz and 3 GHz) and an antenna with narrow bandwidth (resonating with the RF-IC with a high quality factor Q). In such cases a larger voltage swing (for a given needed transmit power) enables the use of an antenna with a higher impedance (e.g. a larger inductance). This gives less on-chip capacitance (for a given frequency of operation), and hence significant IC die area can be saved. Another important benefit of a higher impedance in such systems is that weak received signals also have higher voltage swing. This gives significantly lower current consumption in the receiver and/or better sensitivity of the radio.

Relatively large voltage swing on an antenna can e.g. be adapted to lower levels (e.g. tolerable for an integrated circuit) by a suitable impedance transformation. Such transformation is typically implemented by separate discrete components (off-chip) to limit voltage swing or to maximize design flexibility or to improve the Q-factor or ― in case of large capacitance values ― to decrease costs. In physically small electronic devices, however, where volume is an important limiting parameter (such as e.g. in a portable device, e.g. a listening device, e.g. a hearing aid adapted to be worn at or in the ear of a user), the use of external components is minimized (to save space). Hence, in such cases, it may be preferable to allow the large voltage swing directly on the I/Os of a transceiver IC (e.g. by locating impedance transformation circuitry fully or partly on-chip, cf. our co-pending European patent application no. 10166743.4, which is incorporated herein by reference). The use of standard CMOS or BiCMOS processes is, from a technical as well as an economic point of view, attractive to implement transceiver functions and associated signal processing. Appropriate ESD protection of high-voltage I/Os is needed.

The most common ESD protection devices are based on active devices so they are typically limited to the maximum ratings, which for thick oxide (I/O) transistors of standard CMOS processes e.g. are 1.8 V + 10% or 2.5 V +10% or 3.3 V +10% or 5 V +10% and probably a little bit below ground (less than a threshold or junction diode voltage), i.e. they will typically be limited to the range -0.5 V (or -0.4 V) to 3.6 V (for a standard 3.3 V process).

US 2009/0040670 A1 describes an ESD circuit comprising a chain of diodes and a guard ring, wherein parasitic NPN/PNP bipolar transistors are used. US 6,441,439 B1 describes an electrostatic discharge (ESD) protection device for protecting semiconductor devices against high-voltage transients due to electrostatic discharges. It comprises a plurality of first P+ regions, a plurality of second P+ regions, an N+ region, and an N-type well, which form a plurality of pnp devices connected in parallel to allow a transient voltage to be discharged from the input pad to ground. The N+ region, the P-substrate, and the N-well form an npn device, which is not directly connected to either the ground or the input pad and which allows the transient voltages to be discharged in a reverse direction.

### DISCLOSURE OF INVENTION

If a large voltage swing is desired to maximize the antenna impedance, the only nodes on an RF-IC that need to handle the maximum voltage swing are the I/O terminals which are connected directly to the antenna coil. Preferably (but not necessarily) a differential drive is used, because that maximizes the voltage swing across the antenna and may reduce noise coupling/cross talk. These terminals must be ESD protected.

The idea is to use special diode based ESD protection to enable voltage swing beyond the transistor ratings at the antenna terminals / RF-I/O's on the IC in order to maximize the antenna impedance.

The use of special diode-based electrostatic discharge (ESD) protection can enable higher voltage swing in a standard IC process, which is e.g. beneficial in connection with antenna inputs, e.g. in low power portable communication devices.

Specific implementation(s) of the ESD protection schemes are proposed.

An object of the present application is to provide an integrated circuit in a standard IC process that supports larger than nominal input/output swings. Objects of the application are achieved by the invention described in the accompanying claims and as described in the following.

An object of the application is achieved by a method of ESD protecting high-voltage inputs or outputs of an integrated circuit fabricated in a standard CMOS or BiCMOS IC process, the high-voltage inputs or outputs being allowed to exhibit voltage swings that are larger than the specified maximum I/O voltage of the standard CMOS or BiCMOS IC process. The method comprises,
● Providing an ESD-diode comprising an anode and a cathode and having a forward bias voltage VD-FB above which the diode allows current to flow in a forward direction from the anode to the cathode and a reverse breakdown voltage VD-RB below which the diode allows current to flow in a reverse direction from the cathode to the anode;
● Providing a number of ESD-sub-circuits, each comprising an ESD-diode coupled in series with a resistor, each ESD-sub-circuit having first and second electrical terminals;
● Connecting the ESD-sub-circuits in parallel, the first electrical terminal being connected to a high-voltage input or output of the integrated circuit and the second electrical terminal being connected to a common voltage;
● Providing that the voltage swing of a high-voltage input is in a range between the forward bias voltage VD-FB and the reverse breakdown voltage VD-RB of the ESD-diode.

This has the advantage of facilitating the use of a standard CMOS or BiCMOS process for high-voltage I/Os.

When a suitable impedance transformation is used it is possible to generate and support a relatively large voltage swing on high-voltage I/Os without any active devices (e.g. I/O transistors) being exposed to more than the specified maximum voltage of the standard CMOS process (e.g. 3.3 V +10%) that they can withstand. Exposure to higher voltages causes shorter device life times ― and (depending on the actual voltage) perhaps even instant permanent damage. In an embodiment, the method comprises, providing that high voltage inputs or outputs of an IC implemented in said standard CMOS or BiCMOS IC process comprise passive impedance transformation circuitry.

In the present context, the 'reverse breakdown voltage' of the diode is taken to mean the largest reverse voltage that can be applied to the diode without causing a significant increase in the current. This voltage is sometimes termed the peak inverse voltage (PIV).

The standard IC process may in general be of any kind comprising components (including transistors) for which nominal ratings (e.g. maximum voltages) are specified. Presently known standard IC processes include processes specifying a maximum of 5 V or 3.3 V or 2.5 V or 1.8 V (+10%) input or output voltage. Typically, standard CMOS or BiCMOS (mixed bipolar and CMOS) processes are thought of. In an embodiment, the standard IC process is a CMOS or BiCMOS process wherein a standard thick oxide transistor (e.g. an I/O transistor) is specified to tolerate a maximum of e.g. 5 V or 3.3 V input or output voltage (+10%). Preferably a standard CMOS process is used.

In an embodiment, the method provides that a high voltage swing is larger than 4 V, such as larger than 6 V, such as larger than 8 V, such as larger than 10 V. In an embodiment, the method provides that a high voltage swing is more than twice the specified maximum I/O transistor voltage rating, such as more than 2.5 or 3 times the specified maximum I/O transistor voltage rating.

Preferably, the ESD-diode is selected among the (pn-junction) diodes having the largest reverse breakdown voltage (among the available diodes of the standard IC process in question). In an embodiment, the ESD-diode is an N-well/P-sub diode. Alternatively, other diodes, e.g. P+/Nwell and/or N+/Pwell diodes can be used.

Preferably, the series resistance of an ESD-sub-circuit (a sub-circuit resistance) is selected to provide that the voltage over each sub-circuit resistance is smaller than 1 - 2 V at the specified worst case ESD condition. In an embodiment, the sub-circuit resistance R_{sub-circuit} is in a range from 10 Ω to 500 Ω. The total resistance Rₜₒₜ, is defined here as the slope of the IV curve at sufficiently high bias levels. Rₜₒₜ can be approximated by the equivalent parallel connection of all the sub-circuit resistances i.e. Rₜₒₜ ≈ R_{subcircuit} / n, where n is the number of sub-circuits. In an embodiment, the total resistance Rₜₒₜ is adapted to be in the range [0.3 Ω; 3 Ω]. In an embodiment, where e.g. the number n of sub-circuits is of the order of 100, the sub-circuit resistance R_{sub-circuit} is in the order of 100 Ω (e.g. smaller than 1 kΩ, such as in the range from 50 Ω to 200 Ω).

In a semiconductor process, resistance is defined as the electrical resistance of a square of material having a length L equal to a width W (the sheet resistance). The resistance of a square of 20 µm is e.g. equal to the resistance of a 1 µm by 1 µm square or any other square of the material, because all squares have the same thickness T (the thickness of the layer in question). The sheet resistance R□ of a square of a given conductive layer is given in units of Ω/□. In an embodiment, the series resistance of a sub-circuit is expressed as a certain length L of square material (of width W, e.g. 1 µm) to provide a sub-circuit resistance (L/W)·R□ [Ω]. In an embodiment, the length and width of the sub-circuit resistance is in the range from 0.5 µm to 10 µm, i.e. L, W ∈ [0.5 µm; 10 µm], e.g. [0.5 µm; 5 µm], e.g. [2 µm; 4 µm]. In an embodiment, the series resistance is based on non-salicide N+ poly. In an embodiment, the sheet resistance R□ of non-salicide N+ poly is in the order of 100 Ω. Alternatively, the series resistance can be fully or partially comprised by parasitic well or diffusion or substrate resistance. The smaller the part of the series resistance constituted by parasitic resistance, the better the tolerance on the total resistance will be.

In an embodiment, the number of ESD-sub-circuits is smaller than 300, e.g. smaller than 200. In an embodiment, the number of ESD-sub-circuits is in the range from 2 to 300, e.g. in the range from 2 to 200, e.g. in the range from 10-200, e.g. in the range from 50 to 200.

In an embodiment, the standard CMOS or BiCMOS IC process has a (specified) maximum I/O voltage smaller than or equal to the (specified) maximum rating of the I/O transistors of the process in question, e.g. smaller than or equal to 5 V +10%, such as 3.3 V +10%, such as 2.5 V +10%, such as 1.8 V +10%.

In an embodiment, the maximum voltage swing of a high-voltage input or output is no closer to the reverse breakdown voltage V_{D-RB} than 80% or 90% or 95% of said voltage.

In an embodiment, the high-voltage input or output is adapted to be connected to an antenna terminal of a portable communication device, e.g. a listening device, e.g. a hearing instrument.

In an aspect, an IC implemented in a standard CMOS or BiCMOS process is provided, the IC comprising a number of high voltage I/O pads for handling a high voltage input or output and wherein each high voltage I/O pad is connected to an ESD protection circuit. The ESD protection circuit comprises
a) An ESD-diode comprising an anode and a cathode and having a forward bias voltage V_{D-FB} above which the diode allows current to flow in a forward direction from the anode to the cathode and a reverse breakdown voltage V_{D-RB} below which the diode allows current to flow in a reverse direction from the cathode to the anode; and
b) A number of ESD-sub-circuits, each comprising an ESD-diode coupled in series with a resistor, each ESD-sub-circuit having first and second electrical terminals;
wherein the ESD-sub-circuits are connected in parallel, the first electrical terminal being connected to a high-voltage I/O pad of the IC and the second electrical terminal being connected to a common voltage; and wherein the ESD protection circuit is adapted to protect IC circuitry connected to said high-voltage I/O pad when the voltage swing of said high voltage input or output is in a range between the forward bias voltage V_{D-FB} and the reverse breakdown voltage V_{D-RB} of the ESD-diode.

It is intended that the structural features of the method described above, in the detailed description of 'mode(s) for carrying out the invention' and in the claims can be combined with the IC, when appropriately substituted by a corresponding structural feature and vice versa. Embodiments of the IC have the same advantages as the corresponding method.

The term 'a number of high-voltage I/O pads' is in the present context taken to mean 'at least one high-voltage I/O pad'. In an embodiment, an IC comprises at least two high-voltage I/O pads, e.g. to connect to two terminals of an external antenna (e.g. to enable differential operation of the antenna).

In an embodiment, each high voltage I/O pad is connected to passive impedance transformation circuitry on the IC.

In an embodiment, the number of ESD-sub-circuits (connected to a given I/O pad) is smaller than 300, e.g. smaller than 200. In an embodiment, the number of ESD-sub-circuits is in the range from 2 to 300, e.g. in the range from 2 to 200, e.g. in the range from 10-200, e.g. in the range from 50 to 150. In an embodiment, the number of sub-circuits n is equal to ≈ R_{sub-circuit} / Rₜₒₜ, where R_{sub-circuit} is the resistance of a single sub-circuits and Rₜₒₜ is the total resistance of the n sub-circuits. In an embodiment, the number of sub-circuits n is determined from this relation, wherein R_{sub-circuit} is in a range from 10 Ω to 500 Ω and Rₜₒₜ is in the range [0.3 Ω; 3 Ω].

In an embodiment, the IC comprises transceiver circuitry for transmitting and/or receiving an electromagnetic signal. A transceiver is in the present context taken to mean a circuit that is adapted (together with an external antenna circuit, e.g. an antenna coil or a patch or loop antenna) to transmit and/or receive electromagnetic radiation (be it far-field or near-field). The IC comprising the transceiver circuitry may advantageously comprise other functionality than what is directly related to the transmission and/or reception of an electric signal from an (external) antenna. Such functionality may include modulation/demodulation circuitry, A/D-, D/A-conversion, coding/decoding circuitry, signal processing (e.g. including audio signal processing, noise reduction), etc.

In an embodiment, the transceiver circuitry is connected to at least one of the high voltage swing I/O pads.

In an embodiment, the IC comprises circuitry for tuning an antenna frequency of an external antenna. In an embodiment, the tuning circuitry comprises one or more capacitors or inductors or resistors or a combination thereof.

An article of manufacture comprising an IC as described above, in the detailed description of 'mode(s) for carrying out the invention' and in the claims and a separate antenna circuit, e.g. a coil antenna, is furthermore provided. The terminals of the antenna are electrically connected to high voltage I/O pads of the IC. The antenna circuit is external to the IC (that is, it does not form part of the IC).

In an embodiment, the IC and the antenna are adapted to transmit and/or receive electromagnetic energy at frequencies below 3 GHz, e.g. in a range between 30 MHz and 3 GHz.

In an embodiment, the IC and the antenna are adapted to transmit and/or receive electromagnetic energy at frequencies below 30 MHz, e.g. in a range between 100 kHz and 30 MHz.

In an embodiment, the antenna is differentially coupled to the transceiver IC. Alternatively, the antenna may be single endedly coupled to the transceiver IC.

In an embodiment, the antenna and IC implement a wireless electric interface. In an embodiment, the wireless interface is adapted to transmit and/or receive an audio signal. In the present context, an audio signal comprises frequencies within the human audible range, e.g. in the range from 20 Hz to 20 kHz.

The article of manufacture may in general be of any kind utilizing a wireless interface. In a particular embodiment, the article of manufacture comprises a portable communication device, e.g. a listening device. In a particular embodiment, the article of manufacture comprises a local energy source, e.g. a battery, such as a rechargeable battery, for energizing electronic parts of the article (including the IC).

In an embodiment, the article of manufacture comprises a (possibly standardized) electric interface (e.g. according to a proprietary scheme or to the DECT- or Bluetooth- or WLAN or Zigbee-standards).

In an embodiment, the article of manufacture comprises a communication device, such as a portable device, e.g. a mobile (e.g. cellular) telephone or a listening device. In an embodiment, the listening device comprises a headset or a hearing instrument or a headphone or an active ear protection device or a combination thereof.

In an embodiment, the listening device is adapted to provide a frequency dependent gain to compensate for a hearing loss of a user (e.g. implemented in a signal processing unit).

In an embodiment, the listening device comprises an input transducer (e.g. a microphone system). In an embodiment, the listening device comprises an output transducer (e.g. a speaker-/receiver-unit). In an embodiment, the output transducer is a speaker (receiver). In an embodiment, the output transducer comprises an electrode of a cochlear implant. In an embodiment, the output transducer comprises vibrator of a bone conducting hearing aid.

In an embodiment, the listening device comprises an antenna and transceiver circuitry for receiving a direct electric input signal comprising an audio signal, said transceiver circuitry being implemented in said IC. In an embodiment, the listening device (e.g. the IC) comprises demodulation circuitry for demodulating the received direct electric input to provide the audio signal.

Use of an IC as described above, in the detailed description of 'mode(s) for carrying out the invention' and in the claims is furthermore provided. In an embodiment, use in a listening device, e.g. a hearing instrument, is provided.

Further objects of the application are achieved by the embodiments defined in the dependent claims and in the detailed description of the invention.

As used herein, the singular forms "a," "an," and "the" are intended to include the plural forms as well (i.e. to have the meaning "at least one"), unless expressly stated otherwise. It will be further understood that the terms "includes," "comprises," "including," and/or "comprising," when used in this specification, specify the presence of stated features, integers, steps, operations, elements, and/or components, but do not preclude the presence or addition of one or more other features, integers, steps, operations, elements, components, and/or groups thereof. It will be understood that when an element is referred to as being "connected" or "coupled" to another element, it can be directly connected or coupled to the other element or intervening elements maybe present, unless expressly stated otherwise. Furthermore, "connected" or "coupled" as used herein may include wirelessly connected or coupled. As used herein, the term "and/or" includes any and all combinations of one or more of the associated listed items. The steps of any method disclosed herein do not have to be performed in the exact order disclosed, unless expressly stated otherwise.

### BRIEF DESCRIPTION OF DRAWINGS

The disclosure will be explained more fully below in connection with a preferred embodiment and with reference to the drawings in which:
FIG. 1 shows various ESD protection schemes, FIG. 1 a showing a prior art scheme based on an active device, FIG. 1b showing a prior art scheme based on a chain of diodes, FIG. 1c showing an alternative scheme related to that of FIG. 1b (with no connection to VDD), and FIG. 1d showing an embodiment of a scheme as described in the present disclosure,
FIG. 2 shows an example of a cross-section of a layout of an N_{well}-P_{sub} diode in FIG. 2a and in FIG. 2b a top view illustrating some of the layers of the layout of ring-formed N_{well}-P_{sub} diode arrangement having the cross section shown in FIG. 2a, and
FIG. 3 shows an application of embodiments of an article of manufacture as described in the present disclosure.

The figures are schematic and simplified for clarity, and they just show details which are essential to the understanding of the disclosure, while other details are left out.

Further scope of applicability of the present disclosure will become apparent from the detailed description given hereinafter. However, it should be understood that the detailed description and specific examples, while indicating preferred embodiments of the disclosure, are given by way of illustration only, since various changes and modifications within the spirit and scope of the disclosure will become apparent to those skilled in the art from this detailed description.

### MODE(S) FOR CARRYING OUT THE INVENTION

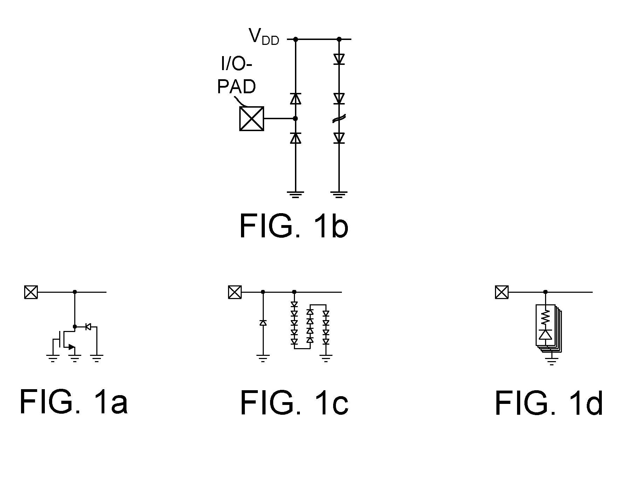

FIG. 1 shows various ESD protection schemes, FIG. 1 a showing a prior art scheme based on an active device, FIG. 1b showing a prior art scheme based on a chain of diodes, FIG. 1c showing an alternative scheme related to that of FIG. 1b (with no connection to VDD), and FIG. 1d showing an embodiment of a scheme as described in the present disclosure.

FIG. 1 a shows a prior art ESD protection circuit comprising a grounded gate NMOS transistor and a diode (a parasitic part of the transistor). A typical input voltage range for the ESD protection circuit of FIG. 1 a is between -0.4 V and +3.6 V. Another well known ESD protection scheme is based on forward biased diodes as shown in FIG. 1 b. A variant of the ESD protection scheme of FIG. 1b wherein the node denoted VDD in FIG. 1b is NOT connected to a common voltage is shown in FIG. 1c. The approximate range of normal operation for the ESD protection circuit of FIG. 1b becomes: -0.5 V to +VDD (+0.5 V). The grounded diode in the left part of FIG. 1b and 1c is e.g. an N+/PWELL junction diode (like the drain and source areas of a standard NMOS). The serially connected diodes to the right in FIG. 1 band 1 c (including the upper left diode in FIG. 1 b) are e.g. P+/NWELL diodes (like the drain and source areas of a standard PMOS) which can be stacked. The reverse breakdown voltage of these diodes is roughly 9 volt in a standard 0.18 µm technology so to only operate with forward biased diodes during an ESD event we need to keep the voltage significantly below this level i.e. the maximum voltage is in the order of e.g. 6-7 V. During normal operation the diodes can usually be forward biased by up to roughly 0.5 V before they start conducting enough current to disturb the normal operation. Therefore 13 diodes are stacked in the figure. And the approximate range for the ESD protection circuit of FIG. 1c becomes: -0.5 V to +6.5 V.

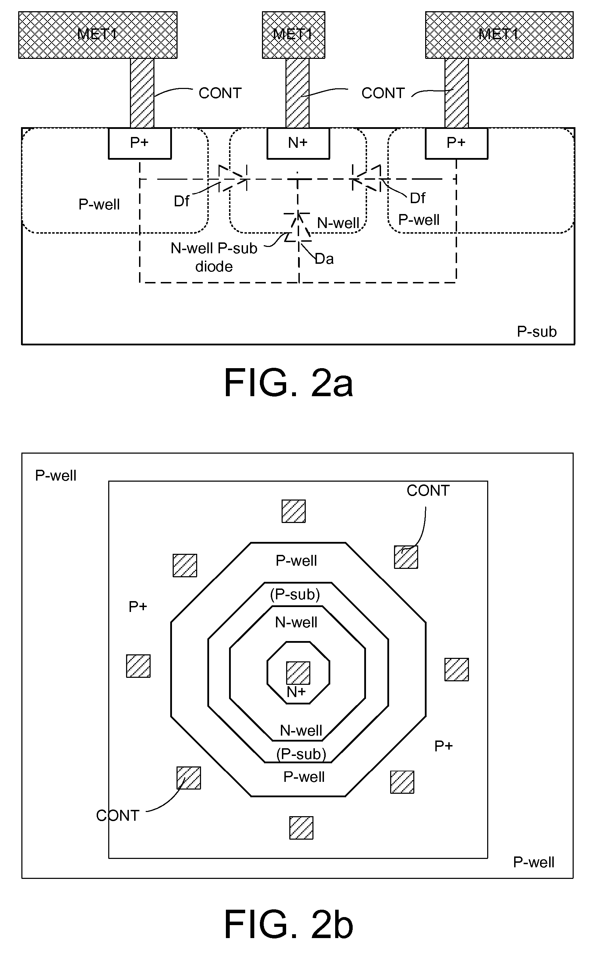

A third ESD protection scheme is shown in figure 1d. The diode with the largest (reverse) breakdown voltage in a typical CMOS technology is the NWELL/PSUB diode. It has a nominal breakdown voltage of 10-15 V. The ESD protection circuit comprises a number of ESD-sub-circuits, each comprising an ESD-diode (e.g. an NWELL/PSUB diode) coupled in series with a resistor, each ESD-sub-circuit having first and second electrical terminals. A number of ESD-sub-circuits (e.g. 100) are connected in parallel, the first electrical terminal of each ESD sub-circuit being connected to a high-voltage input of the IC and the second electrical terminal of each ESD sub-circuit being connected to a common voltage (e.g. ground). A typical input voltage range for the ESD protection circuit of FIG. 1c is between -0.5 V and +11 V. A schematic drawing of a physical layout of an N-well/P-sub diode is shown in FIG. 2.

FIG. 2 shows an example of a cross-section of a layout of an Nwell-Psub diode in FIG. 2a and in FIG. 2b a top view illustrating some of the layers of the layout of ring-formed Nwell-Psub diode arrangement having the cross section shown in FIG. 2a. In an aspect of the invention, it is proposed to use a number of parallel diodes in an ESD protection circuit as part of a high voltage protection scheme involving forward as well as reverse biasing. Preferably, the diode arrangement is laid out in an array to minimize chip area. In an embodiment, the ESD protection circuit comprises an ordinary PN-junction diode. In an embodiment, the ESD protection circuit comprises an N-well/P-sub diode. The reverse breakdown phenomenon is nondestructive as long as the current does not rise to levels where the local thermal heating causes damage. Hence, the challenge is to make sure that a single one of the protection devices does not break down before the others (which would result in the one device sinking all current and subsequent overheating and meltdown). Such current limiting is typically handled in breakdown devices by inserting a small series resistor in series with each protection device (often by blocking salicide and reducing the number of contacts), cf. e.g. FIG. 1d. Here it is desirable to insert a dedicated (e.g. poly) resistor (having less process variation) because it is the junction itself that breaks down (not a parasitic NPN). If for instance we assume that we will use 100 small NWELL/PSUB diodes and the protection should be able to handle 2 kV ESD events (human body model (HBM)), then each device should be able to handle (2000V/1500Ω)/100 = 13 mA. We assume that a 1.3 V drop over the resistor is sufficient (we hereby assume that the matching of the breakdown voltages is better than 1.3 V (9%) which should be possible with identical layouts). Then we need sub-circuit resistors of ≈1.3 V/13 mA = 100 Ω. A typical sheet resistance of non-salicide N+ poly for a standard CMOS process is 100-200Ω so this corresponds to roughly one square (the other types are higher in resistance and as such are less convenient in shape factor). Also N+ poly has the highest allowable current density during an ESD event (e.g. 15-25 mA/µm). So it seems that an L = W = 1 µm resistor is sufficient (which has the advantage of small layout and limited parasitic bottom plate capacitance), L being the length and W the width of the layout of the resistor. To be on the safe side, a physically somewhat larger sub-circuit resistor is preferably used, e.g. a resistor with dimensions (L and/or W) in the 2-4 µm range (i.e. L, W ∈ [2 µm; 4 µm], L, W not necessarily being equal). The voltage range is -0.5 V (forward bias) to roughly +11 to +12 V (reverse breakdown voltage ― 20% for process spread).

FIG. 2a shows a cross sectional view of some of the layers of a ring formed diode arrangement comprising *N-well-P-sub* diodes, which is shown in a top view in FIG. 2b. As illustrated in FIG. 2b, the ring formed circuit is centred around an N+-diffusion in an *N-well* area embedded in *P-sub* material. A contact (*CONT*) provides electrical contact between the N+-diffusion and metal conductors (*MET1* in FIG. 2a) for connecting to other components on the substrate (or external to the substrate). The central *N-well* area is surrounded by (optionally separated, by a small width *P*-*sub*-ring (as shown here, and indicated by the parenthesis '(•)' around *P-sub* in FIG. 2b), from) a ring of *P*+-diffusion in a *P-well* area embedded in *P-sub* material. The ring layout may take any other form appropriate for the application in question as an alternative to the ring formed arrangement illustrated in FIG. 2b. Further, the dimensions, forms and widths of the different structures may be different and are not necessarily to scale. The forms and minimum dimensions are e.g. dependent on the design rules for the process in question. Likewise, the number, form and location of the contacts may be different from what is exemplified in FIG. 2b.

In FIG. 2a, the various contributions to the *N-well-P-sub* diodes of the layout are schematically indicated. Depending on the dimensions of the N-well (in particular the thickness to width ratio, the side wall (fringe) contribution *Df* may or may not be significant (even dominant) relative to the area contribution Da.

### Example:

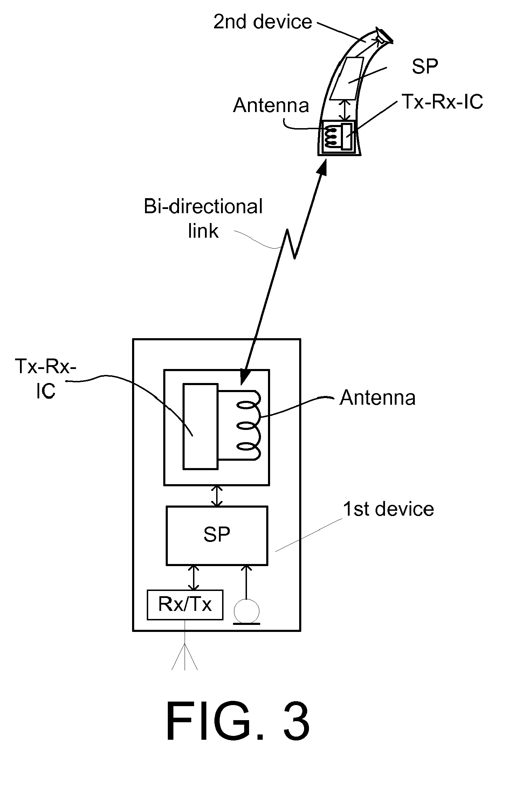

FIG. 3 shows an application of embodiments of an article of manufacture as described in the present disclosure. The system shown in FIG. 3 comprises embodiments of 1^{st} and 2^{nd} articles of manufacture according to the present disclosure. The first and second articles of manufacture (1^{st} and *2^{nd} device,* respectively) each comprises a coil antenna *(Antenna)* connected to a transceiver IC (*Tx*-*Rx*-*IC*) comprising ESD protection circuitry according to an embodiment of the present invention (cf. e.g. FIG. 1d). The second article of manufacture *(2^{nd} device)* is here shown to have the form of a listening device, e.g. a head set or a hearing instrument (here shown as a behind the ear part of a hearing instrument). The 1^{st} and 2^{nd} devices both comprise a signal processing unit (SP), here shown separately from the transceiver ICs, adapted for communicating with the respective transceiver ICs. Alternatively, the signal processing units may fully or partially form part of the transceiver ICs of the 1^{st} and/or 2^{nd} devices. The *2^{nd} device* comprises a speaker connected to the signal processing device and adapted for presenting a processed audio signal to a user as an acoustic signal. The *1^{st} device* comprises a microphone for picking up an acoustic signal from the environment and a further antenna (and corresponding transceiver circuitry *Rx*/*Tx*) for receiving and/or transmitting a wireless signal (e.g. comprising an audio signal) from/to another device. The microphone and the antenna/transceiver circuitry are connected to the signal processing unit (SP) for further processing and communication with the transceiver IC (*Tx-Rx*-*IC*) and/or with the transceiver circuitry *Rx*/*Tx.* The signal processing units of the 1^{st} and 2^{nd} devices may perform functional tasks of the devices in question, e.g. audio processing, e.g. providing a frequency dependent gain to compensate for a user's hearing impairment and/or other signal enhancement features (e.g. noise reduction). The *1^{st} device* can e.g. be a mobile telephone or an intermediate device (e.g. an audio gateway) between a communication device (e.g. a mobile telephone) or an (audio) entertainment device and the *2^{nd} device.* The *2^{nd} device* can e.g. be a listening device, such as a headset or an earphone or a hearing instrument or an audio protection device (or a combination thereof). In an embodiment, the *Bi-directional link* between the 1^{st} and 2^{nd} devices is based on a magnetic coupling (reactive near-field) between respective antenna coils of the two devices. Alternatively, it may be based on electromagnetic radiation (far-field).

The wireless link between the 1^{st} and 2^{nd} device is indicated to be bi-directional, but may just as well be uni-directional (e.g. where the 1^{st} and 2^{nd} devices comprise only transmitter and receiver circuitry, respectively). A protocol for a uni-directional inductive link is e.g. described in US 2005/0255843 A1. An example of a system comprising a hearing instrument and an audio selection device is e.g. described in EP 1 460 769 A1. Inductive communication (i.e. communication based on electromagnetic *induction* as opposed to electromagnetic *radiation)* between a hearing instrument and a gateway device in accordance with a standard or proprietary protocol is e.g. described in EP 1 480 492 A2. The wireless link may e.g. carry an audio signal (e.g. streaming audio from an entertainment device or a telephone), e.g. in stereo. The bandwidth or bit rate of the signal to be transmitted may be adapted to be in the order of tens or hundreds of kHz (kbit/s) or in the order of MHz (Mbit/s) or higher. The range of the link may be adapted to be in the range from a few centimetres to tens of meters. In a preferred embodiment, the range is adapted to distances occurring for devices to be worn on a persons' body (e.g. less than 2 m such as less than 1 m, such as less than 0.5 m).

The invention is defined by the features of the independent claim(s). Preferred embodiments are defined in the dependent claims. Any reference numerals in the claims are intended to be non-limiting for their scope.

Some preferred embodiments have been shown in the foregoing, but it should be stressed that the invention is not limited to these, but may be embodied in other ways within the subject-matter defined in the following claims.

### REFERENCES

■ US 2009/0040670 A1 (Van Camp et al.) 12-02-2009
■ US 6,441,439 B1 (WINBOND ELECTRONIC) 27-08-2002
■ US 2005/0255843 A1 (Hilpisch et al.) 17-11-2005
■ EP 1 460 769 A1 (PHONAK) 22-09-2004
■ EP 1 480 492 A2 (SIEMENS AUDIOLOGISCHE TECHNIK) 24-11-2004

## Claims

1. A method of ESD protecting high-voltage inputs or outputs of an integrated circuit fabricated in a standard CMOS or BiCMOS IC process, the high-voltage inputs or outputs being allowed to exhibit voltage swings that are larger than the specified maximum I/O voltage of the standard CMOS or BiCMOS IC process, the method comprising
a. Providing an ESD-diode comprising an anode and a cathode and having a forward bias voltage V_{D-FB} above which the diode allows current to flow in a forward direction from the anode to the cathode and a reverse breakdown voltage V_{D-RB} below which the diode allows current to flow in a reverse direction from the cathode to the anode;
b. Providing a number of ESD-sub-circuits, each comprising an ESD-diode coupled in series with a resistor, each ESD-sub-circuit having first and second electrical terminals;
c. Connecting the ESD-sub-circuits in parallel, the first electrical terminal being connected to a high-voltage input or output of the integrated circuit and the second electrical terminal being connected to a common voltage;
d. Providing that the voltage swing of a high-voltage input is in a range between the forward bias voltage V_{D-FB} and the reverse breakdown voltage V_{D-RB} of the ESD-diode.

2. A method according to claim 1 wherein the ESD-diode is selected among the PN-junction diodes having the largest reverse breakdown voltage.

3. A method according to claim 1 or 2 wherein the ESD-diode is an N-well/P-sub diode.

4. A method according to any one of claims 1-3 wherein the series resistance is arranged to have a length L and a width W in the range from 0.5 µm to 10 µm, such as in the 1-4 µm range.

5. A method according to any one of claims 1-4 wherein the series resistance is based on non-salicide N+ poly.

6. A method according to any one of claims 1-5 wherein the number of ESD-sub-circuits is in the range from 2 to 300, e.g. from 50 to 200.

7. A method according to any one of claims 1-6 wherein the standard CMOS IC process has a specified maximum voltage smaller than 5 Volt + 10%, e.g. equal to 3.3 Volt +10%.

8. A method according to any one of claims 1-7 wherein the nominal voltage swing of a high-voltage input is no closer to the reverse breakdown voltage V_{D-RB} than 80% or 90% or 95% of said voltage.

9. A method according to any one of claims 1-8 wherein the high-voltage input or output is adapted to be connected to an antenna terminal of a portable communication device, e.g. a listening device, e.g. a hearing instrument.

10. An IC implemented in a standard CMOS or BiCMOS process, the IC comprising a number of high voltage I/O pads for handling a high voltage input or output and wherein each high voltage I/O pad is connected to an ESD protection circuit, the ESD protection circuit comprising
a. An ESD-diode comprising an anode and a cathode and having a forward bias voltage V_{D-FB} above which the diode allows current to flow in a forward direction from the anode to the cathode and a reverse breakdown voltage V_{D-RB} below which the diode allows current to flow in a reverse direction from the cathode to the anode;
b. A number of ESD-sub-circuits, each comprising an ESD-diode coupled in series with a resistor, each ESD-sub-circuit having first and second electrical terminals;
c. Wherein the ESD-sub-circuits are connected in parallel, the first electrical terminal being connected to a high-voltage I/O pad of the IC and the second electrical terminal being connected to a common voltage; and
d. Wherein the ESD protection circuit is adapted to protect IC circuitry connected to said high-voltage I/O pad when the voltage swing of said high voltage input or output is in a range between the forward bias voltage V_{D-FB} and the reverse breakdown voltage V_{D-RB} of the ESD-diode.

11. An IC according to claim 10 wherein the circuitry connected to at least one of the high voltage I/O pads is adapted to be connected to an external antenna, e.g. a coil antenna.

12. An IC according to claim 11 wherein the IC comprises circuitry for tuning an antenna frequency of the external antenna.

13. An article of manufacture comprising an IC according to any one of claims 10-12 and a separate antenna, e.g. a coil antenna, wherein the terminals of the antenna are electrically connected to high voltage I/O pads of the IC.

14. An article of manufacture according to claim 13 wherein the IC and the antenna are adapted to transmit and/or receive electromagnetic energy at frequencies below 3 GHz, e.g. in a range between 30 MHz and 3 GHz.

15. An article of manufacture according to claim 13 wherein the IC and the antenna are adapted to transmit and/or receive electromagnetic energy at frequencies below 30 MHz, e.g. in a range between 100 kHz and 30 MHz.
